# FASCICULE DE BREVET EUROPEEN

(11) **EP 3 295 472 B1**
(45) Date de publication et mention de la délivrance du brevet: **17.11.2021**
(21) Numéro de dépôt: 16729024.6
(22) Date de dépôt: 13.05.2016
(51) Int. Cl.: H01L 21/18, H01L 21/02

(54) **PROCEDE DE COLLAGE D'UNE PREMIERE STRUCTURE ET D'UNE SECONDE STRUCTURE**
VERFAHREN ZUM ANHAFTEN EINER ERSTEN STRUKTUR UND EINER ZWEITEN STRUKTUR
METHOD FOR ADHERING A FIRST STRUCTURE AND A SECOND STRUCTURE

(30) Priorité: 13.05.2015 FR 1554340
(43) Date de publication de la demande: 21.03.2018
(73) Titulaire: Commissariat à l'Énergie Atomique et aux Énergies Alternatives, 75015 Paris (FR)
(72) Inventeur: IMBERT, Bruno, 38000 Grenoble (FR); BENAISSA, Lamine, 38000 Grenoble (FR); GONDCHARTON, Paul, 38100 Grenoble (FR)
(74) Mandataire: Cabinet Beaumont
(86) Numéro de dépôt international: PCT/FR2016/051148
(87) Numéro de publication internationale: WO 2016/181090

(56) Documents cités:
- FR-A1- 3 006 236
- FR-A1- 3 009 428
- US-A1- 2014 073 112

## Description

La présente invention a trait à un procédé de collage d'une première structure et d'une seconde structure, la première structure et la seconde structure comportant chacune au moins une couche métallique.

Par « couche métallique », on entend une couche à base d'un métal (métal pur ou alliage métallique), ou à base d'un oxyde métallique.

Le collage de telles structures est notamment utilisé dans la microélectronique afin d'empiler des composants. A titre d'exemples non limitatifs, on peut citer comme domaines d'application :
- la fabrication de circuits intégrés 3D par intégration 3D séquentielle ou monolithique,
- la fabrication de composants optiques, photovoltaïques, ou de puissance,
- le conditionnement de microsystèmes électromécaniques (MEMS).

Selon la nature des première et seconde structures, le collage peut être du type :
- tranche semi-conductrice à tranche semi-conductrice (« *Wafer-to-Wafer, WtW* » en langue anglaise),
- carré de circuit imprimé à carré de circuit imprimé (« *Die-to-Die, DtD* » en langue anglaise),
- carré de circuit imprimé à tranche semi-conductrice (« *Die-to-Wafer, DtW* » en langue anglaise).

Un premier procédé de collage connu de l'état de la technique, notamment des documents A. Shigetou et al., « Modified diffusion bonding for both Cu and SiO2 at 150°C in ambient air », ECTC Proceedings 60th, 2010, pp. 872-877 et T. Shimatsu et al., « Atomic diffusion bonding of wafers with thin nanacrystalline métal films », J. Vac. Sci. Technol. B Microelectron. Nanometer Struct., vol. 28, n°4, 2010, pp. 706-714, comporte une étape de collage des première et seconde structures par adhésion directe des couches métalliques, les couches métalliques étant à base d'un métal. Un tel premier procédé de l'état de la technique s'effectue sous ultra-vide (c'est-à-dire dans une atmosphère présentant une pression classiquement inférieure à 10⁻⁷ Pa) dans un bâti dédié, et ce afin d'empêcher la formation d'un oxyde métallique natif à la surface desdites couches métalliques. Un tel premier procédé de l'état de la technique n'est pas entièrement satisfaisant en raison du coût élevé d'un bâti dédié à la formation d'un ultra-vide.

Un deuxième procédé de collage connu de l'état de la technique, notamment du document P. Gondcharton et al, « Mechanisms overview of thermocompression process for copper metal bonding », MRS Online Proc. Libr., vol. 1559, 2013, comporte une étape de collage des première et seconde structures par thermocompression des couches métalliques, chaque couche métallique comportant successivement une couche à base d'un métal et une couche à base d'un oxyde métallique. L'oxyde métallique est classiquement un oxyde natif. Un tel deuxième procédé, se faisant en température, permet de supprimer les oxydes métalliques entre les couches à base d'un métal. Ce budget thermique conduit à la fermeture de l'interface de collage, mais présente un temps de procédé long (le plus souvent un seul collage par thermocompression), et donc plus coûteux.

Un troisième procédé de collage connu de l'état de la technique, notamment du document L. Di Cioccio et al., « Modeling and intégration phenomena of metal-metal direct bonding technology », ECS Trans., vol. 64, n°5, 2014, pp. 339-355, comporte une étape de collage des première et seconde structures par adhésion directe des couches métalliques, chaque couche métallique comportant successivement une couche à base d'un métal et une couche à base d'un oxyde métallique. L'oxyde métallique est classiquement un oxyde natif. Un tel troisième procédé comporte préalablement une étape de polissage mécano-chimique (CMP pour « *Chemical Mechanical Polishing* » en langue anglaise) afin d'aplanir et d'activer la surface des couches à base d'un oxyde métallique. Un tel troisième procédé est suivi d'un recuit thermique adapté pour favoriser l'appauvrissement en oxygène de l'interface de collage. Dans le cas d'une structure de collage utilisant le couple Cu/CuOₓ, il permet la dissolution de l'oxyde métallique dès 200°C et de fait un contact électrique conducteur. Pour un autre couple métal/oxyde comme Ti/TiOₓ, la conduction électrique de l'interface de collage peut être augmentée dès 200°C-300°C par la faculté du Ti à solubiliser l'oxygène dans sa matrice. Dans cette même publication, est référencé le cas du collage tungstène avec son oxyde natif. Cet oxyde est présent à l'interface de collage jusqu'à plus de 600°C, température qui est élevée pour la réalisation de composants de la microélectronique. La cinétique d'appauvrissement en oxygène peut ainsi, suivant les matériaux mis en œuvre, être lente.

FR 3 006 236 A1, US 2014/073112 A1 et FR 3 009 428 A1 divulguent des procédés de collage selon l'art antérieur.

Ainsi, la présente invention vise à remédier en tout ou partie aux inconvénients précités, et concerne à cet effet un procédé de collage d'une première structure et d'une seconde structure, comportant les étapes :
a) prévoir la première structure comportant successivement un premier substrat, une première couche réalisée dans un premier matériau à base d'un métal, et un premier oxyde métallique à base du métal,
b) prévoir la seconde structure comportant successivement un second substrat, une seconde couche, et un
   second oxyde métallique à base du métal, le second oxyde métallique étant en contact direct avec la seconde couche, les premier et second oxydes métalliques présentant une enthalpie libre standard de formation à partir du métal, notée ΔG°,
c) coller la première structure et la seconde structure par adhésion directe entre le premier oxyde métallique et le second oxyde métallique,
d) activer la diffusion des atomes d'oxygène des premier et second oxydes métalliques vers la seconde couche, caractérisé en ce que la seconde couche est réalisée dans un second matériau, le second matériau étant choisi de sorte qu'il possède un oxyde présentant une enthalpie libre standard de formation à partir du second matériau strictement inférieure à ΔG° entre 298 K et 1000 K et au moins à la température à laquelle est exécutée l'étape d pour appauvrir en oxygène les premier et second oxydes métalliques, et en ce que la diffusion des atomes d'oxygène est activée de manière à former l'oxyde du second matériau dans tout ou partie de l'épaisseur de la second couche.

Ainsi, un tel procédé selon l'invention permet d'améliorer significativement la conduction électrique de l'interface de collage relativement à l'état de la technique en appauvrissant en oxygène les premier et second oxydes métalliques lors de l'étape d), tout en conservant l'intégrité de l'interface de collage. De plus, un tel procédé permet la gestion de l'eau piégée à l'interface de collage de manière à prévenir la formation d'un oxyde au niveau de cette interface. En outre, les premier et second oxydes métalliques appauvris en oxygène lors de l'étape d) présentent une conductivité électrique s'approchant de celle du métal, ce qui permet de former une interface de collage électriquement conductrice, ce qui peut être avantageux pour certaines applications nécessitant des interconnexions verticales. Par ailleurs, les premier et second oxydes métalliques sont à base du même métal et permettent d'obtenir un collage symétrique lors de l'étape c), contribuant à la bonne qualité de l'interface de collage.

Le second matériau est choisi de sorte qu'il possède un oxyde présentant une enthalpie libre standard de formation à partir du second matériau strictement inférieure à ΔG° entre 298 K et 1000 K et au moins à la température à laquelle est exécutée l'étape d pour appauvrir en oxygène les premier et second oxydes métalliques. En d'autres termes, cette condition nécessaire traduit le fait que le second matériau est accepteur d'oxygène avec un pouvoir réducteur sur les premier et second oxydes métalliques. Le second matériau est donc nécessairement choisi différent du premier matériau. Il en résulte que le second oxyde métallique, à base du métal du premier matériau, ne peut être un oxyde natif du second matériau.

Le fait que le second oxyde métallique est en contact direct avec la seconde couche permet d'éviter la présence d'une barrière de diffusion des atomes d'oxygène qui serait interposée entre la seconde couche et le second oxyde métallique.

L'oxyde du second matériau est formée dans tout ou partie de l'épaisseur de la seconde couche selon le niveau d'appauvrissement en oxygène souhaité dans les premier et second oxydes métalliques, et selon la valeur de l'épaisseur initiale de la seconde couche lors de l'étape b).

Le collage de l'étape c) est effectué par adhésion directe. On entend par « adhésion directe » un collage issu de la mise en contact direct de deux surfaces, c'est-à-dire en l'absence d'un élément additionnel tel qu'une colle, une cire ou encore une brasure. L'adhésion provient principalement des forces de Van der Waals issues de l'interaction électronique entre les atomes ou les molécules des deux surfaces. On parle également de collage par adhésion moléculaire.

Dans un mode de réalisation, l'étape b) comporte une étape b1) consistant à former des plots métalliques dans toute l'épaisseur de la seconde couche.

Ainsi, de tels plots métalliques permettent d'assurer une conductivité électrique à travers la seconde couche, et ce malgré la formation de l'oxyde du second matériau lors de l'étape d) qui est classiquement un isolant électrique. Ceci est particulièrement avantageux pour certaines applications nécessitant des interconnexions verticales.

Le second oxyde métallique présente une partie située en regard de chaque plot métallique. Les plots métalliques sont avantageusement dimensionnés de sorte que les atomes d'oxygène de la partie du second oxyde métallique puissent diffuser vers la seconde couche de part et d'autre du plot métallique correspondant. Chaque plot métallique présente avantageusement une largeur comprise entre 10 nm et 100 nm. Chaque plot métallique s'étend suivant une direction longitudinale parallèle au plan défini par le second substrat. Par « largeur », on entend une dimension suivant une direction perpendiculaire à la direction longitudinale, et parallèle au plan défini par le second substrat.

Selon une forme d'exécution, la première structure et la seconde structure collées lors de l'étape c) forment un ensemble, et l'étape d) est exécutée en appliquant un recuit thermique à l'ensemble.

Ainsi, un tel recuit thermique présente un budget thermique adapté pour permettre à la fois :
- de faire diffuser des atomes d'oxygène des premier et second oxydes métalliques vers la seconde couche de manière à former l'oxyde du second matériau dans tout ou partie de l'épaisseur de la seconde couche,
- de renforcer l'interface de collage.

Par « budget thermique », on entend une température de recuit et une durée de recuit.

Selon une variante d'exécution, l'étape d) est exécutée en appliquant une différence de potentiel entre les premier et second substrats.

Il faut dans ce cas que les premier et second substrats soient suffisamment conducteurs (substrats métalliques ou fortement dopés). La différence de potentiel appliquée entre les premier et second substrats est adaptée pour faire diffuser des atomes d'oxygène des premier et second oxydes métalliques vers la seconde couche de manière à former l'oxyde du second matériau dans tout ou partie de l'épaisseur de la seconde couche.

L'étape d) est alors avantageusement suivie d'une étape e) appliquer un recuit thermique à l'ensemble formé par les première et seconde structures collées. Un tel recuit thermique présente un budget thermique adapté pour renforcer l'interface de collage. Un tel budget thermique est réduit relativement au budget thermique nécessaire pour faire diffuser des atomes d'oxygène des premier et second oxydes métalliques vers la seconde couche de manière à former l'oxyde du second matériau dans tout ou partie de l'épaisseur de la seconde couche.

Selon un mode de mise en œuvre, l'étape a) comporte une étape a1) consistant à former le premier oxyde métallique sur la première couche de manière contrôlée et l'étape b) comporte une étape b2) consistant à former le second oxyde métallique sur la seconde couche de manière contrôlée.

Ainsi, le premier oxyde métallique n'est pas un oxyde natif qui se forme de manière spontanée dans une atmosphère oxydante. Il est alors possible de contrôler notamment l'épaisseur et la stœchiométrie du premier oxyde métallique. De même, comme précisé précédemment, le second oxyde métallique n'est pas non plus un oxyde natif du second matériau dans la mesure où le second matériau est nécessairement choisi différent du premier matériau, et le second oxyde métallique est à base du métal du premier matériau. De tels premier et second oxydes métalliques permettent donc d'améliorer la qualité de l'interface de collage.

Selon une forme d'exécution, les étapes a1) et b2) sont exécutées par une technique sélectionnée dans le groupe comportant un dépôt physique en phase vapeur, un dépôt chimique en phase vapeur, une oxydation thermique.

Selon un mode de mise en œuvre :
- le premier matériau est à base de tungstène,
- les premier et second oxydes métalliques sont à base de WOₓ, x étant compris entre 1 et 4,
- le second matériau est à base de silicium, de préférence à base de silicium amorphe,
- l'oxyde du second matériau est à base d'une phase oxydée de silicium.

WOₓ est de préférence du dioxyde de tungstène WO₂, ou du trioxyde de tungstène WO₃. La phase oxydée de silicium est de préférence du dioxyde de silicium.

Ainsi, si l'on note ΔG° l'enthalpie libre standard de formation de WOₓ, x étant compris entre 1 et 4, (par exemple le dioxyde de tungstène WO₂ ou le trioxyde de tungstène WO₃) à partir du métal tungstène W, le second matériau à base de silicium (ou de silicium amorphe) est choisi car il possède une phase oxydée, par exemple le dioxyde de silicium, présentant une enthalpie libre standard de formation à partir du silicium (ou du silicium amorphe) strictement inférieure à ΔG°, la différence étant de l'ordre de 300 kJ/mol entre 298 K et 1000 K.

Avantageusement, le recuit thermique présente :
- une température de recuit comprise entre 100°C et 600°C, de préférence comprise entre 350°C et 550°C.
- une durée de recuit supérieure à 30 min, de préférence supérieure à 1 h.

Ainsi, un tel budget thermique permet à la fois :
- de faire diffuser des atomes d'oxygène de WOₓ, x étant compris entre 1 et 4, (par exemple le dioxyde de tungstène WO₂ ou le trioxyde de tungstène WO₃) vers la seconde couche à base de silicium ou de silicium amorphe de manière à former une phase oxydée de silicium dans tout ou partie de l'épaisseur de la seconde couche.
- de renforcer la fermeture de l'interface de collage.

En outre, le silicium amorphe est particulièrement avantageux dans la mesure où il a été constaté expérimentalement qu'il favorisait l'appauvrissement en oxygène du dioxyde de tungstène WO₂ ou du trioxyde de tungstène WO₃ relativement à du silicium monocristallin.

Le second matériau est choisi de sorte qu'il possède un oxyde présentant une enthalpie libre standard de formation à partir du second matériau strictement inférieure à ΔG° entre 298 K et 1000 K et au moins à la température (ou au moins sur la gamme de température) à laquelle est exécutée l'étape d).

Ainsi, l'appauvrissement en oxygène des premier et second oxydes métalliques est favorisé.

D'autres caractéristiques et avantages apparaîtront dans la description qui va suivre de différents modes de réalisation de l'invention, données à titre d'exemples non limitatifs, en référence aux dessins annexés dans lesquels :
- la figure 1 est une vue schématique en coupe illustrant les différentes étapes d'un procédé de l'invention selon un premier mode de réalisation,
- la figure 2 est une vue schématique en coupe illustrant les différentes étapes d'un procédé de l'invention selon un deuxième mode de réalisation,
- la figure 3 est un diagramme d'Ellingham représentant l'enthalpie libre standard de formation d'un oxyde (en kJ/mol) à partir de métaux ou de semiconducteurs en fonction de la température (en K).

Pour les différents modes de réalisation, les mêmes références seront utilisées pour des éléments identiques ou assurant la même fonction, par souci de simplification de la description. Les caractéristiques techniques décrites ci-après pour différents modes de réalisation sont à considérer isolément ou selon toute combinaison techniquement possible.

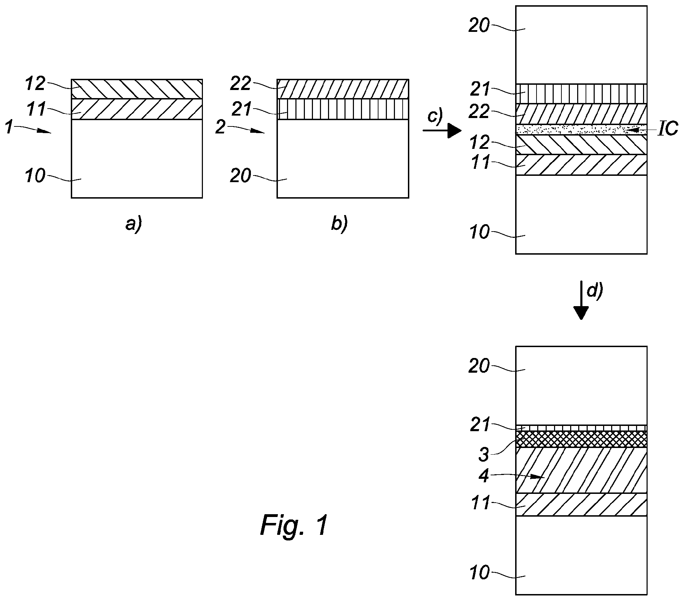

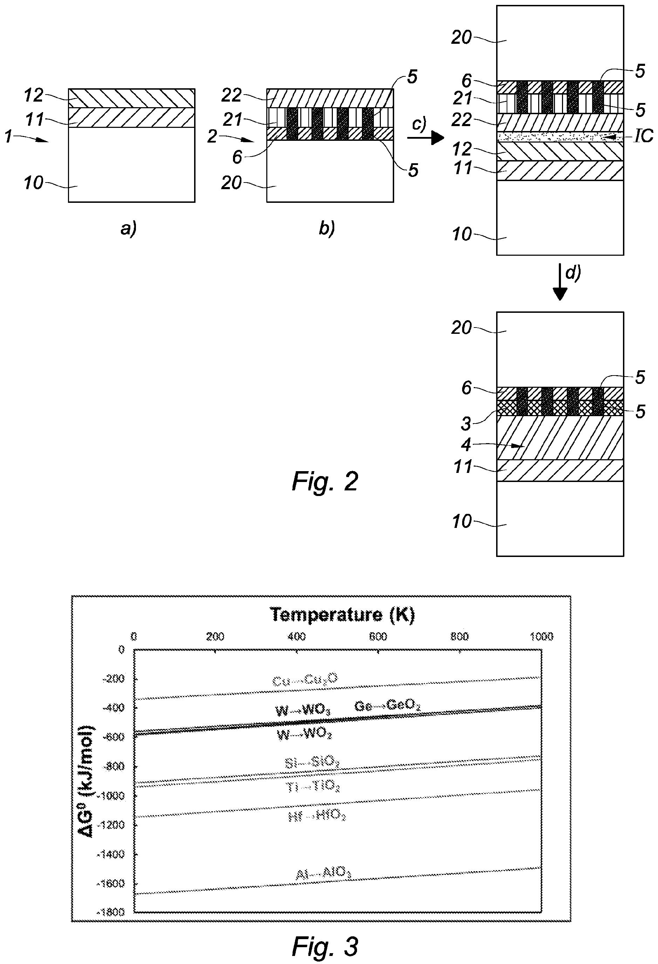

Le procédé illustré aux figures 1 et 2 est un procédé de collage d'une première structure 1 et d'une seconde structure 2, comportant les étapes :
a) prévoir la première structure 1 comportant successivement un premier substrat 10, une première couche 11 réalisée dans un premier matériau à base d'un métal, et un premier oxyde métallique 12 à base du métal,
b) prévoir la seconde structure 2 comportant successivement un second substrat 20, une seconde couche 21, et un
   second oxyde métallique 22 à base du métal, le second oxyde métallique 22 étant en contact direct avec la seconde couche 21, les premier et second oxydes métalliques 12, 22 présentant une enthalpie libre standard de formation à partir du métal, notée ΔG°,
c) coller la première structure 1 et la seconde structure 2 par adhésion directe entre le premier oxyde métallique 12 et le second oxyde métallique 22,
d) activer la diffusion des atomes d'oxygène des premier et second 30 oxydes métalliques 11, 12 vers la seconde couche 21, caractérisé en ce que la seconde couche 21 est réalisée dans un second matériau, le second matériau étant choisi de sorte qu'il possède un oxyde 3 présentant une enthalpie libre standard de formation à partir du second matériau strictement inférieure à ΔG° entre 298 K et 1000 K et au moins à la température à laquelle est exécutée l'étape d pour appauvrir en oxygène les premier et second oxydes métalliques, et en ce que la diffusion des atomes d'oxygène est activée de manière à former l'oxyde 3 du second matériau dans tout ou partie de l'épaisseur de la second couche 21.

L'étape a) comporte avantageusement les étapes :
- a0) fournir le premier substrat 10,
- a01) former la première couche 11 sur le premier substrat 10,
- a02) former le premier oxyde métallique 12 sur la première couche 11.

Les étapes a01) et a02) sont avantageusement exécutées au sein d'un même bâti afin d'éviter la formation d'un oxyde natif sur la première couche 11. L'étape a) comporte avantageusement une étape a1) consistant à former le premier oxyde métallique 12 sur la première couche 11 de manière contrôlée. L'étape a1) est avantageusement exécutée par une technique sélectionnée dans le groupe comportant un dépôt physique en phase vapeur, un dépôt chimique en phase vapeur, une oxydation thermique.

L'étape b) comporte avantageusement les étapes :
- b0) fournir le second substrat 20,
- b01) former la seconde couche 21 sur le second substrat 20,
- b02) former le second oxyde métallique 22 sur la seconde couche 21 en contact direct.

Les étapes b01) et b02) sont avantageusement exécutées au sein d'un même bâti afin d'éviter la formation d'un oxyde natif du second matériau entre la seconde couche 21 et le second oxyde métallique 22. L'étape b) comporte avantageusement une étape b2) consistant à former le second oxyde métallique 22 sur la seconde couche 21 de manière contrôlée. L'étape b2) est avantageusement exécutée par une technique sélectionnée dans le groupe comportant un dépôt physique en phase vapeur, un dépôt chimique en phase vapeur.

Les premier et second substrats 10, 20 présentent avantageusement une rugosité surfacique inférieure à 1 nm en moyenne quadratique (RMS) sur un scan de 20 x 20 µm² évaluée par un microscope à force atomique (AFM). Les premier et second substrats 10, 20 sont avantageusement réalisés dans un matériau sélectionné dans le groupe comportant un métal, un semi-conducteur, une céramique.

Le choix du second matériau s'effectue avantageusement en consultant un diagramme d'Ellingham tel qu'illustré à la figure 3. Ainsi, ΔG° est matérialisée par une première droite. L'enthalpie libre standard de formation de l'oxyde 3 à partir du second matériau est matérialisée par une seconde droite. Le second matériau est choisi de sorte que la seconde droite se situe au-dessous de la première droite dans le diagramme d'Ellingham.

L'exécution de l'étape c) conduit à la formation d'une interface de collage IC comportant des molécules d'eau apportées par l'atmosphère sous laquelle est exécutée l'étape c). Le collage peut être par exemple réalisé sous air, à pression atmosphérique et à température ambiante.

L'exécution de l'étape d) conduit à :
- la formation d'une zone électriquement conductrice 4 issue de l'appauvrissement en oxygène des premier et second oxydes métalliques 12, 22,
- la formation de l'oxyde 3 du second matériau dans tout ou partie de l'épaisseur de la seconde couche 21.

La première structure 1 et la seconde structure 2 collées lors de l'étape c) forment un ensemble 1, 2, et l'étape d) est avantageusement exécutée en appliquant un recuit thermique à l'ensemble 1, 2.

Selon un premier mode de mise en œuvre :
- le premier matériau est à base de tungstène, la première couche 11 présentant de préférence une épaisseur de 20 nm,
- les premier et second oxydes métalliques 12, 22 sont à base de dioxyde de tungstène WO₂, ou à base de trioxyde de tungstène WO₃, les premier et second oxydes métalliques présentant de préférence une épaisseur de 10 nm,
- le second matériau est à base de silicium, de préférence à base de silicium amorphe, la seconde couche 21 présentant de préférence une épaisseur de 10 nm,
- l'oxyde 3 du second matériau est à base d'une phase oxydée de silicium, par exemple le dioxyde de silicium.

« Par épaisseur », on entend une dimension perpendiculaire au plan défini par un substrat 10, 20.

Comme illustré à la figure 3, le second matériau à base de silicium (monocristallin ou polycristallin ou amorphe) est choisi de sorte qu'il possède un oxyde, le dioxyde de silicium, présentant une enthalpie libre standard de formation à partir du silicium (monocristallin ou amorphe) strictement inférieure à ΔG° du couple W/WO₂ ou du couple W/WO₃.

Les premier et second substrats 10, 20 sont avantageusement réalisés dans un matériau à base de silicium.

Les étapes a01), a02) et b02) sont avantageusement exécutées au sein d'un bâti de pulvérisation cathodique sous plasma réactif à température ambiante, c'est-à-dire entre 20°C et 30°C. Les étapes a02) et b02) sont avantageusement exécutées sous un plasma comportant du dioxygène. Les premier et second oxydes métalliques 12, 22 formés lors des étapes a02) et b02) présentent une résistivité comprise entre 5.10⁻² et 5.10⁻³ Ω.cm⁻¹.

L'étape c) est exécutée à l'atmosphère ambiante, c'est-à-dire avec une pression de l'ordre de 1013,25 hPa et une humidité relative de 40% d'eau, et à la température ambiante, c'est-à-dire comprise entre 20°C et 30°C.

Lors de l'exécution de l'étape d), le recuit thermique appliqué à l'ensemble 1, 2 présente :
- une température de recuit comprise entre 100°C et 600°C, de préférence comprise entre 350°C et 550°C, plus préférentiellement comprise entre 450°C et 550°C,
- une durée de recuit supérieure à 30 min, de préférence supérieure à 1 h, plus préférentiellement supérieure à 2 h.

Le recuit thermique est avantageusement appliqué dans une atmosphère inerte, non oxydante, c'est-à-dire sous atmosphère de N₂, Ar ou sous vide.

Il a été constaté expérimentalement par une analyse en microscopie électronique en transmission que :
- l'interface de collage IC n'est plus visible après l'étape d),
- l'oxyde 3 a été formé dans l'épaisseur de la seconde couche 21.

Comme illustré à la figure 2, l'étape b) comporte avantageusement une étape b1) former des plots métalliques 5 dans toute l'épaisseur de la seconde couche 21. Le second substrat 20 est avantageusement recouvert d'une couche diélectrique 6. Les plots métalliques 5 s'étendent avantageusement dans toute l'épaisseur de la couche diélectrique 6 de manière à former par exemple un niveau d'interconnexion d'un CMOS. La couche diélectrique 6 est avantageusement réalisée dans un matériau identique à l'oxyde 3 du second matériau afin d'homogénéiser l'isolation électrique des plots métalliques 5.

Le second oxyde métallique 22 présente une partie située en regard de chaque plot métallique 5. Les plots métalliques 5 sont avantageusement dimensionnés de sorte que les atomes d'oxygène de ladite partie du second oxyde métallique 22 puissent diffuser vers la seconde couche 21 de part et d'autre du plot métallique 5 correspondant. Chaque plot métallique 5 présente avantageusement une largeur comprise entre 10 nm et 100 nm. Chaque plot métallique 5 s'étend suivant une direction longitudinale parallèle au plan défini par le second substrat 20. Par « largeur », on entend une dimension suivant une direction perpendiculaire à la direction longitudinale, et parallèle au plan défini par le second substrat 20.

Un tel procédé permet ainsi une intégration 3D monolithique d'un empilement de transistors.

## Revendications

1. Procédé de collage d'une première structure (1) et d'une seconde structure (2), comportant les étapes :
a) prévoir la première structure (1) comportant successivement un premier substrat (10), une première couche (11) réalisée dans un premier matériau à base d'un métal, et un premier oxyde métallique (12) à base du métal,
b) prévoir la seconde structure (2) comportant successivement un second substrat (20), une seconde couche (21), et
un second oxyde métallique (22) à base du métal, le second oxyde métallique (22) étant en contact direct avec la seconde couche (21), les premier et second oxydes métalliques (12, 22) présentant une enthalpie libre standard de formation à partir du métal, notée ΔG°,
c) coller la première structure (1) et la seconde structure (2) par adhésion directe entre le premier oxyde métallique (12) et le second oxyde métallique (22),
d) activer la diffusion des atomes d'oxygène des premier et second oxydes 20 métalliques (12, 22) vers la seconde couche (21), **caractérisé en ce que** la seconde couche (21) est réalisée dans un second matériau, le second matériau étant choisi de sorte qu'il possède un oxyde (3) présentant une enthalpie libre standard de formation à partir du second matériau strictement inférieure à ΔG° entre 298 K et 1000 K et au moins à la température à laquelle est exécutée l'étape d pour appauvrir en oxygène les premier et second oxydes métalliques, et **en ce que** la diffusion des atomes d'oxygène est activée de manière à former l'oxyde (3) du second matériau dans tout ou partie de l'épaisseur de la second couche (21).

2. Procédé selon la revendication 1, **caractérisé en ce que** l'étape b) comporte une étape b1) consistant à former des plots métalliques (5) dans toute l'épaisseur de la seconde couche (21).

3. Procédé selon la revendication 1 ou 2, **caractérisé en ce que** la première structure (1) et la seconde structure (2) collées lors de l'étape c) forment un ensemble (1, 2), et **en ce que** l'étape d) est exécutée en appliquant un recuit thermique à l'ensemble (1, 2).

4. Procédé selon la revendication 1 ou 2, **caractérisé en ce que** l'étape d) est exécutée en appliquant une différence de potentiel entre les premier et second substrats (10, 20).

5. Procédé selon l'une des revendications 1 à 4, **caractérisé en ce que** l'étape a) comporte une étape a1) consistant à former le premier oxyde métallique (12) sur la première couche (11) de manière contrôlée, et **en ce que** l'étape b) comporte une étape b2) consistant à former le second oxyde métallique (22) sur la seconde couche (21) de manière contrôlée.

6. Procédé selon la revendication 5, **caractérisé en ce que** les étapes a1) et b2) sont exécutées par une technique sélectionnée dans le groupe comportant un dépôt physique en phase vapeur, un dépôt chimique en phase vapeur, une oxydation thermique.

7. Procédé selon l'une des revendications 1 à 6, **caractérisé en ce que** :
- le premier matériau est à base de tungstène,
- les premier et second oxydes métalliques (12, 22) sont à base de WOₓ, x étant compris entre 1 et 4,
- le second matériau est à base de silicium, de préférence à base de silicium amorphe,
- l'oxyde (3) du second matériau est à base d'une phase oxydée de silicium.

8. Procédé selon la revendication 7 en combinaison avec la revendication 3, **caractérisé en ce que** le recuit thermique présente :
- une température de recuit comprise entre 100°C et 600°C, de préférence comprise entre 350°C et 550°C.
- une durée de recuit supérieure à 30 min, de préférence supérieure à 1 h.

## Patentansprüche

1. Verfahren zum Bonden oder Verbinden einer ersten Struktur (1) mit einer zweiten Struktur (2), wobei das Verfahren die folgenden Schritte aufweist:
a) Bereitstellen der ersten Struktur (1), die nacheinander ein erstes Substrat (10), eine erste Schicht (11) aus einem ersten Material auf der Basis eines Metalls und ein erstes Metalloxid (12) auf der Basis des Metalls aufweist,
b) Bereitstellen der zweiten Struktur (2), die nacheinander ein zweites Substrat (20), eine zweite Schicht (21) und ein zweites Metalloxid (22) auf der Basis des Metalls aufweist, wobei das zweite Metalloxid (22) in direktem Kontakt mit der zweiten Schicht (21) steht und das erste und das zweite Metalloxid (12, 22) eine freie Standardbildungsenthalpie des Metalls, die als ΔG° notiert ist, aufweisen,
c) Bonden der ersten Struktur (1) mit der zweiten Struktur (2) durch direkte Adhäsion zwischen dem ersten Metalloxid (12) und dem zweiten Metalloxid (22),
d) Aktivieren der Diffusion der Sauerstoffatome der ersten und des zweiten Metalloxide (12, 22) zu der zweiten Schicht (21), **dadurch gekennzeichnet, dass** die zweite Schicht aus einem zweiten Material hergestellt ist, wobei das zweite Material so gewählt ist, dass es ein Oxid (3) aufweist, das eine freie Standardbildungsenthalpie des zweiten Materials aufweist, die zwischen 298 K und 1000 K strikt unter ΔG° liegt, und wenigstens bei der Temperatur bei dem Schritt d ausgeführt wird, um den Sauerstoffgehalt des ersten und des zweiten Metalloxids zu vermindern, und dass die Diffusion der Sauerstoffatome so aktiviert wird, dass das Oxid (3) des zweiten Materials über die gesamte oder einen Teil der Dicke der zweiten Schicht (21) gebildet wird.

2. Verfahren nach Anspruch 1, wobei Schritt b) einen Schritt b1) aufweist, der in der Bildung von Metallbumps (5) über die gesamte Dicke der zweiten Schicht (21) besteht.

3. Verfahren nach Anspruch 1, wobei die erste Struktur (1) und die zweite Struktur (2), die in Schritt c) gebondet werden, eine Anordnung (1, 2) bilden, und wobei Schritt d) durch Anlegen eines thermischen Anneals oder Temperns an die Anordnung (1, 2) ausgeführt wird.

4. Verfahren nach Anspruch 1, wobei Schritt d) durch Anlegen einer Potentialdifferenz zwischen dem ersten und dem zweiten Substrat (10, 20) ausgeführt wird.

5. Verfahren nach Anspruch 1, wobei Schritt a) einen Schritt a1) aufweist, der darin besteht, das erste Metalloxid (12) auf der ersten Schicht (11) in kontrollierter Weise auszubilden, wobei Schritt b) einen Schritt b2) aufweist, der darin besteht, das zweite Metalloxid (22) auf der zweiten Schicht (21) in kontrollierter Weise auszubilden.

6. Verfahren nach Anspruch 5, wobei die Schritte a1) und b2) durch eine Technik ausgeführt werden, die aus der folgenden Gruppe ausgewählt ist, physikalische Gasphasenabscheidung, chemische Gasphasenabscheidung und thermische Oxidation.

7. Verfahren nach Anspruch 1, wobei:
- das erste Material Wolframbasierend ist,
- die ersten und zweiten Metalloxide (12, 22) auf WOₓ basieren, wobei x zwischen 1 und 4 liegt,
- das zweite Material Siliziumbasierend ist, vorzugsweise auf amorphem Silizium basiert,
- das Oxid (3) des zweiten Materials auf einer oxidierten Siliziumphase basiert.

8. Verfahren nach Anspruch 7 in Kombination mit Anspruch 3, wobei das thermische Annealen oder Tempern Folgendes aufweist
- eine Annealtemperatur zwischen 100°C und 600°C, vorzugsweise zwischen 350°C und 550°C.
- eine Annealzeit von mehr als 30 Minuten, vorzugsweise mehr als 1 Stunde.

## Claims

1. Bonding method of a first structure (1) with a second structure (2), comprising the following steps:
a) providing the first structure (1) successively comprising a first substrate (10), a first layer (11) made from a first material based on a metal, and a first metal oxide (12) based on the metal,
b) providing the second structure (2) successively comprising a second substrate (20), a second layer (21), and a second metal oxide (22) based on the metal, the second metal oxide (22) being in direct contact with the second layer (21), the first and second metal oxides (12, 22) presenting a standard free enthalpy of formation from the metal, noted ΔG°,
c) bonding the first structure (1) with second structure (2) by direct adhesion between the first metal oxide (12) and the second metal oxide (22),
d) activating diffusion of the oxygen atoms of the first and second metal oxides (12, 22) to the second layer (21), **characterized in that** the second layer is made from a second material, the second material being chosen so that it has an oxide (3) presenting a standard free enthalpy of formation from the second material strictly lower than ΔG° between 298 K and 1000 K and at least at the temperature is executed step d to deplete the oxygen content of the first and second metal oxides, and **in that** the diffusion of the oxygen atoms is activated so as to form the oxide (3) of the second material in all or part of the thickness of the second layer (21).

2. Method according to claim 1, wherein step b) comprises a step b1) consisting in forming metallic bumps (5) in the whole thickness of the second layer (21).

3. Method according to claim 1, wherein the first structure (1) and the second structure (2) bonded in step c) form an assembly (1, 2), and wherein step d) is executed by applying a thermal anneal to the assembly (1, 2).

4. Method according to claim 1, wherein step d) is executed by applying a potential difference between the first and second substrates (10, 20).

5. Method according to claim 1, wherein step a) comprises a step a1) consisting in forming the first metal oxide (12) on the first layer (11) in controlled manner, wherein step b) comprises a step b2) consisting in forming the second metal oxide (22) on the second layer (21) in controlled manner.

6. Method according to claim 5, wherein steps a1) and b2) are executed by a technique selected from the group comprising physical vapor deposition, chemical vapor deposition, and thermal oxidation.

7. Method according to claim 1, wherein:
- the first material is tungsten-based,
- the first and second metal oxides (12, 22) are based on WOₓ, x being comprised between 1 and 4,
- the second material is silicon-based, preferably amorphous silicon-based,
- the oxide (3) of the second material is based on an oxidized silicon phase.

8. Method according to claim 7 in combination with claim 3, wherein the thermal anneal presents:
- an annealing temperature comprised between 100°C and 600°C, preferably comprised between 350°C and 550°C.
- an annealing time of more than 30 min, preferably more than 1 h.
